(19) **Europäisches Patentamt**

**European Patent Office**

**Office européen des brevets**

(11) **EP 1 049 162 A2**

(12) **EUROPEAN PATENT APPLICATION**

(43) Date of publication:
02.11.2000 Bulletin 2000/44

(51) Int. Cl.[7]: **H01L 23/498**

(21) Application number: **00108979.6**

(22) Date of filing: **27.04.2000**

(84) Designated Contracting States:
**AT BE CH CY DE DK ES FI FR GB GR IE IT LI LU MC NL PT SE**
Designated Extension States:
**AL LT LV MK RO SI**

(30) Priority: **27.04.1999 JP 11902699**

(71) Applicant: **NEC CORPORATION**
**Tokyo (JP)**

(72) Inventor:
**Sakurai, Junya,**
**c/o NEC Corporation**
**Tokyo (JP)**

(74) Representative: **Betten & Resch**
**Reichenbachstrasse 19**
**80469 München (DE)**

(54) **Interconnection structure of a multilayer circuit board for electrical connection to a semiconductor package and manufacturing method thereof**

(57) A printed circuit board (10) of a multilayer structure has a plurality of pads (12B, 12C) embedded together with a wiring pattern (11) in an inner layer thereof. An insulating material on the pads (12B, 12C) is removed from the printed circuit board (10) to form recesses (14B, 14C) through which the pads (12B, 12C) are exposed. A semiconductor package (22) is placed on the printed circuit board (11), and solder balls (20B, 20C) of the semiconductor package (22) are directly connected to the pads (12B, 12C) through the recesses (14B, 14C).

**FIG.3**

**EP 1 049 162 A2**

## Description

BACKGROUND OF THE INVENTION

Field of the Invention

This invention relates to a connection method and structure of a semiconductor package to a printed circuit board of a multilayer structure, and more particularly to a method of and a structure for connecting a solder ball or a pin directly to a printed circuit board without using a through hole or a blind via hole (BVH).

Description of the Related Art

Various improvements in a package which uses a ball grid array (BGA) are disclosed. For example, a BGA package is disclosed in Japanese Patent Laid-Open No. Hei 9-8166 wherein pads of different sizes are arranged in a grid-like configuration in order to reduce appearance of defective semiconductor bridges and so forth. Another BGA package is disclosed in Japanese Patent Laid-Open No. Hei 9-199540 wherein small bumps and large bumps are used in order to prevent fatigue failure of bumps.

In a conventional printed circuit board of a multilayer structure on which a BGA package is mounted, where a large number of pads are formed in concentrical rows thereon, through-holes or blind via holes are used to connect wiring lines to an inner layer in order to lead out the wiring lines from the pads of an inner one of the rows.

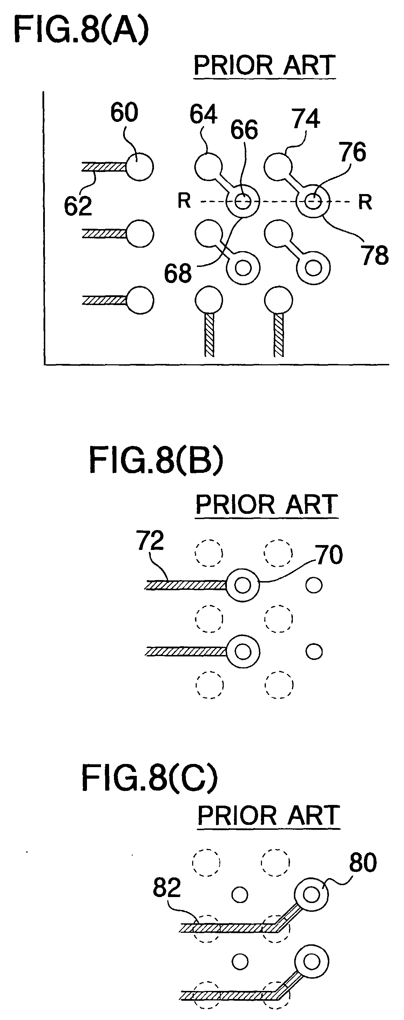

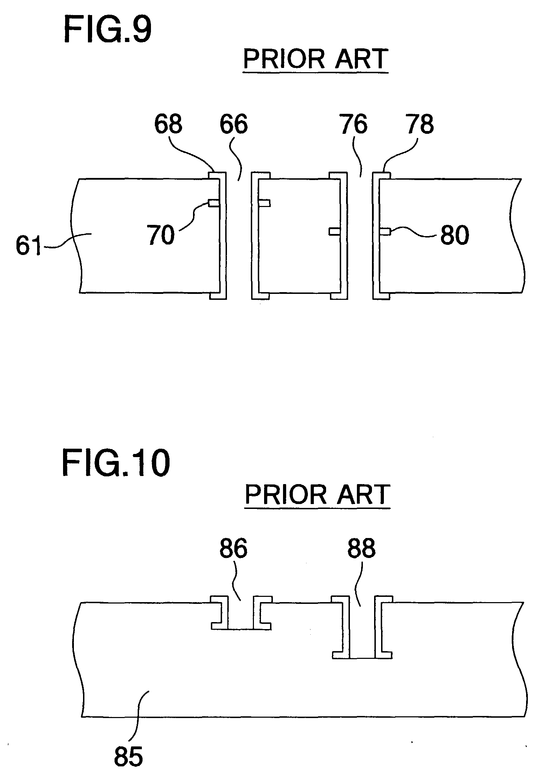

FIGS. 8(A) to 8(C) and 9 show a structure of a printed circuit board of a multilayer structure where a through-hole is used. More particularly, FIGS. 8(A), 8(B) and 8(C) are top plan views of the first, second and third layers of the printed circuit board, respectively. FIG. 9 is a cross sectional view taken along line X-X of FIG. 8(A).

Referring to FIGS. 8(A) to 8(C) and 9, the printed circuit board 61 has pads 60, 64 and 74 arranged in rectangular concentrical rows thereon. As particularly shown in FIG. 8(A), the pads 60 on the outermost row on the first layer allow wiring lines 62 to be led out therefrom toward the outer side of the printed circuit board 61. Meanwhile, the pads 64 on the middle row are connected to lands 68 of through-holes 66 on the first layer and further connected to wiring lines 72 through lands 70 of the through-holes 66 on the second layer as shown in FIG. 8(B).

Further, the pads 74 on the innermost row of FIG. 8(A) are connected to lands 78 of through-holes 76 on the first layer and further connected to wiring lines 82 through lands 80 of the through-holes 76 on the third layer as shown in FIG. 8(C).

Subsequently, a structure of a printed circuit board of a multilayer structure where a blind via hole is used, is described. FIG. 10 shows a cross section of a printed circuit board 85 of a three-layer structure which employs a blind via hole. Blind via holes 86 and 88 shown in FIG. 10 interconnect lands of different layers but do not extend through the printed circuit board 85. Such blind via holes are preferable in order to miniaturize an apparatus. Wiring lines are led out from the lands of the different layers in a similar manner as with through-holes.

In the conventional printed circuit boards described above, whichever one of a through-hole and a blind via hole is employed, there is a problem that, as the arrangement pitch of pads decreases, it becomes difficult to lay a wiring line between pads or between lands. A possible solution to this problem is to reduce the size of pads or lands. However, the solution still has a limitation.

Further, where a through-hole is employed, since it extends through a circuit board, when wiring on a certain layer is considered, no wiring line can be laid at a location at which a through-hole is present. Therefore, there is a problem that a wiring line must be laid bypassing any through-hole. Although this problem can be solved where a blind via hole is used, a printed circuit board which uses a blind via hole has a unique problem that it requires a greater number of production steps when compared with production of another printed circuit board which employs a through-hole. Further, where a blind via hole is used, there is a problem that, as the number of inner layers from which wiring lines are to be led out increases, the number of stages (which corresponds to the number of steps for formation of holes) increases and also the cost increases.

SUMMARY OF THE INVENTION

It is an object of the present invention to provide a connection method and structure to a printed circuit board which does not require a through-hole or a blind via hole.

In order to attain the object described above, according to an aspect of the present invention, there is provided connection method to a printed circuit board for establishing electric connection to a pad embedded together with a wiring line in an inner layer of a printed circuit board of a multilayer structure, comprising the steps of removing an insulating material on the pad to form a recessed portion in the printed circuit board to expose the pad through the recessed portion, and connecting a connection member directly to the pad through the recessed portion.

According to another aspect of the present invention, there is provided a connection method to a printed circuit board for electrically connecting a connection member of a semiconductor package to a pad embedded together with a wiring line in an inner layer of a printed circuit board of a multilayer structure, comprising the steps of removing an insulating material on the pad to form a recessed portion of a depth corresponding to the size of the connection member in the printed circuit board to expose the pad through the recessed portion, and placing the semiconductor package onto the printed circuit board and connecting the connection member directly to the pad through the recessed portion.

According to a further aspect of the present invention, there is provided a connection structure to a printed circuit board for establishing electric connection to a pad embedded together with a wiring line in an inner layer of a printed circuit board of a multilayer structure, comprising a recessed portion formed on the pad and defined by an insulating material for exposing the pad therethrough, and a connection member connected directly to the pad through the recessed portion.

According to a still further aspect of the present invention, there is provided a connection structure to a printed circuit board for electrically connecting a connection member of a semiconductor package to a pad embedded together with a wiring line in an inner layer of a printed circuit board of a multilayer structure, comprising a recessed portion of a depth corresponding to the size of the connection member formed on the pad in the printed circuit board and defined by an insulating material for exposing the pad therethrough, the connection member arranged on the semiconductor package being connected directly to the pad through the recessed portion.

In the connection methods and structures, the connection member preferably is a solder ball or a pin and may be provided on the semiconductor package or some other member. Another connection member of the semiconductor package may be connected to another pad provided on the surface of the printed circuit board. The recessed portion may be formed by mechanical spot facing of the insulating material or by thermal vaporization of the insulating material by a laser.

Where a plurality of solder balls are arranged in concentrical rows on the semiconductor package, preferably they are arranged such that the diameter increases as the arrangement position comes toward the center of the rows. Meanwhile, where a plurality of pins are arranged in concentric rows on the semiconductor package, preferably they are arranged such that the length increases as the arrangement position comes toward the center of the rows. Preferably, the plurality of solder balls or pins are arranged such that the arrangement pitch thereof increases from the outer row toward the inner row.

With the connection methods and structures, since the connection member is connected directly to the pad of the inner layer of the printed circuit board of a multilayer structure, the necessity for provision of a through-hole or a blind via hole for wiring to the printed circuit board is eliminated, and wiring is facilitated thereby.

Particularly where the semiconductor package to be connected to the printed circuit board has a plurality of solder balls or pins arranged thereon, wiring to the inner layer is facilitated by arranging the solder balls or the pins such that the diameter of the solder ball or the length of the pin increases as the arrangement position comes toward the center of the rows.

With the connection methods and structures, the following effects are achieved.

1. Effects on wiring and production of a printed circuit board

As solder balls or pins are directly connected to pads provided in an inner layer of a printed circuit board through-holes or blind via holes for leading out wiring lines are unnecessary. Since through-holes are unnecessary, the area for wiring lines increases and leading out of wiring lines from a ball grid array or pins is facilitated. Further, while use of a blind via hole results in increase of the number of steps of production of holes as the number of stages increases, with the connection methods, only one step of spot facing is required.

2. Effects on electric characteristics

As a ball grid array or pins are connected directly to a printed circuit board without using through-holes or blind via holes, there are advantages that electric loss can be reduced and the ground characteristic is augmented. Further, impedance matching can be established readily because there is no electric point of discontinuity.

3. Effect upon solder connection

As spot facing is performed for each pad of a printed circuit board, a wall-shaped insulator remains around the pad. The insulator has an effect of preventing a solder bridge between adjacent pads upon soldering of a ball grid array.

The above and other objects, features and advantages of the present invention will become apparent from the following description and the appended claims, taken in conjunction with the accompanying drawings in which like parts or elements are denoted by like reference symbols.

BRIEF DESCRIPTION OF THE DRAWINGS

FIGS. 1(A) to 1(C) show a printed circuit board of a multilayer structure to which the present invention is applied, and wherein FIG. 1(A) is a cross sectional view of the printed circuit board before pads are exposed, FIG. 1(B) is a top plan view of the printed circuit board after the pads are exposed, and FIG. 1(C) is a sectional view taken along line X-X of FIG.

1(B);

FIGS. 2(A) and 2(B) show a BGA package to be connected to the printed circuit board of FIGS. 1(A) to 1(C), and wherein FIG. 2(A) is a bottom plan view of the BGA package and FIG. 2(B) is a sectional view taken along line Y-Y of FIG. 2(A);

FIG. 3 is a cross sectional view showing a connection between the printed circuit board of FIGS. 1(A) to 1(C) and the BGA package of FIGS. 2(A) and 2(B);

FIG. 4 is a bottom plan view of a modification to the BGA package of FIGS. 2(A) and 2(B) wherein solder balls are arranged such that the pitch thereof decreases toward an outer row;

FIGS. 5(A) and 5(B) show a pin package to be connected to the printed circuit board of FIGS. 1(A) to 1(C), and wherein FIG. 5(A) is a bottom plan view of the pin package and FIG. 5(B) is a sectional view taken along line Z-Z of FIG. 5(A);

FIG. 6 is a cross sectional view showing a connection between the printed circuit board of FIGS. 1(A) to 1(C) and the pin package of FIGS. 5(A) and 5(B);

FIG. 7 is a enlarged side elevational view showing a pin of the pin package of FIGS. 5(A) and 5(B) soldered to a pad;

FIGS. 8(A), 8(B) and 8(C) are top plan views of first, second and third layers, respectively, of a conventional printed circuit board of a multilayer structure wherein a through-hole is used;

FIG. 9 is an enlarged sectional view taken along line R-R of FIG. 8(A); and

FIG. 10 is a cross sectional view of a printed circuit board of a multilayer structure wherein a blind via hole is used.

DESCRIPTION OF THE PREFERRED EMBODIMENTS

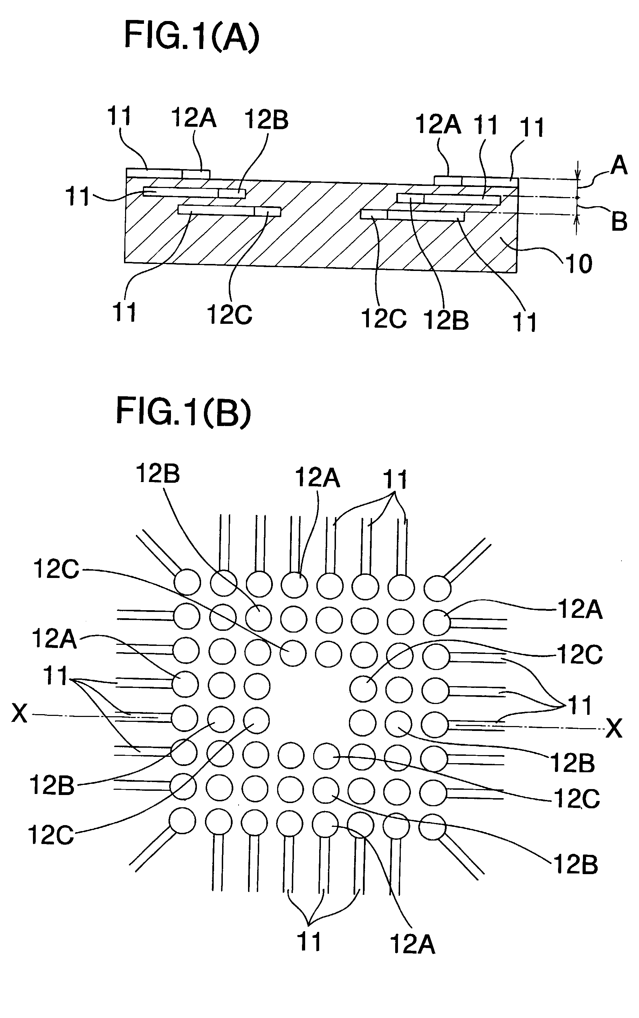

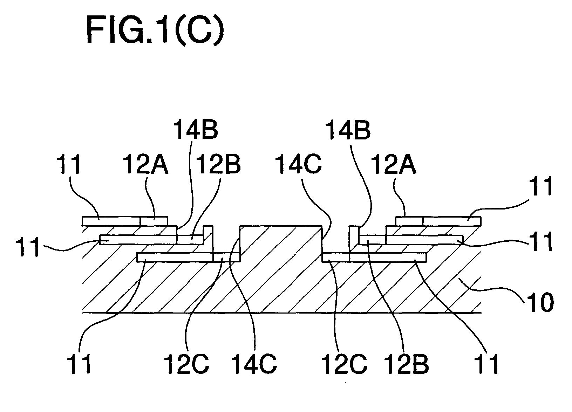

FIGS. 1(A) to 1(C) shown a printed circuit board of a multilayer structure which employs a ball grid array (BGA) connection to which the present invention is applied.

Referring first to FIG. 1(A), the printed circuit board of a multilayer structure is generally denoted at 10 and includes a large number of pads 12B embedded together with wiring patterns 11 in an inner layer at a shallower place thereof, and a large number of pads 12C embedded together with wiring patterns 11 also in another inner layer at a deeper place thereof. Further, a large number of pads 12A are formed together with wiring patterns 11 on the surface of the printed circuit board 10. The pads 12A, 12B and 12C are arranged in a generally concentric square configuration as seen in FIG. 1(B).

In order to produce the printed circuit board 10, an insulating material located on the pads 12B and 12C embedded in the printed circuit board is removed by mechanical spot facing by a milling machine or spot facing by thermal vaporization by a laser to form such recesses 14B and 14C as shown in FIGS. 1(A) and 1(B) to expose the pads 12B and 12C in the inner layers. In the printed circuit board 10 shown, the recesses 14B and 14C are substantially cylindrical recesses and individually have the same diameters. The diameters are selected so as to be greater than the greatest one of diameters of solder balls provided on a BGA package which is hereinafter described.

The pads 12A, 12B and 12C have circular shapes of the same size as viewed in the top plan view of FIG. 1(A) and are arranged in a grid-like configuration in an equal pitch.

After such spot facing for forming the recesses extending to the pads in the inner layers as described above, walls 16 of the insulating material which forms the printed circuit board 10 remain between the recesses as shown in FIG. 1(C).

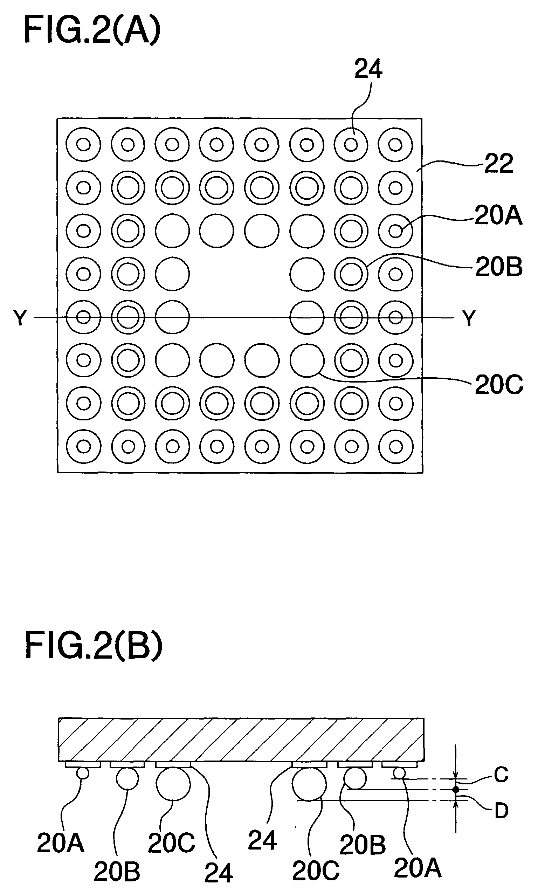

FIGS. 2(A) and 2(B) show a ball grind array (BGA) package to be connected to the printed circuit board 10 of FIGS. 1(A) to 1(C).

Referring to FIGS. 2(A) and 2(B), the BGA package is generally denoted at 22 and includes an array of solder balls arranged in such a manner as shown in FIGS. 2(A) and 2(B) on circular pads 24 of the same size which are arranged in a grid-like configuration in an equal pitch on a package body. It is to be noted that the array of circular pads 24 corresponds in a one-by-one corresponding relationship to the array of the pads 12A, 12B and 12C of the printed circuit board 10.

Solder balls 20A disposed on the outermost row along the four sides of the BGA package 22, solder balls 20B disposed on the middle row along the four sides of the BGA package 22 and solder balls 20C disposed on the innermost row along the four sides of the BGA package 22 have different diameters from one another, and the diameter increases from the outermost row toward the innermost row. The diameters of the solder balls are selected in the following manner. In particular, where, in FIG. 1(A), the distance between the top face of a pad 12A and the top face of a pad 12B is represented by A and the distance between the top face of a pad 12B and the top face of a pad 12C is represented by B, if, in FIG. 2(B), the distance between the top of a solder ball 20A and the top of a solder ball 20B is represented by C and the distance between the top of a solder ball 20B and the top of a solder ball 20C is represented by D, then the diameters of the solder balls are selected such that $A = C$ and $B = D$ may be satisfied.

As an example, if the pads 12A, 12B and 12C have an equal thickness of 0.018 mm, and A = 0.1 mm, B = 0.1 mm, the diameter of the solder balls 20A is 0.4 mm, the diameter of the solder balls 20B is 0.5 mm, and the diameter of the solder balls 20C is 0.6 mm, then C = 0.1 mm and D = 0.1 mm.

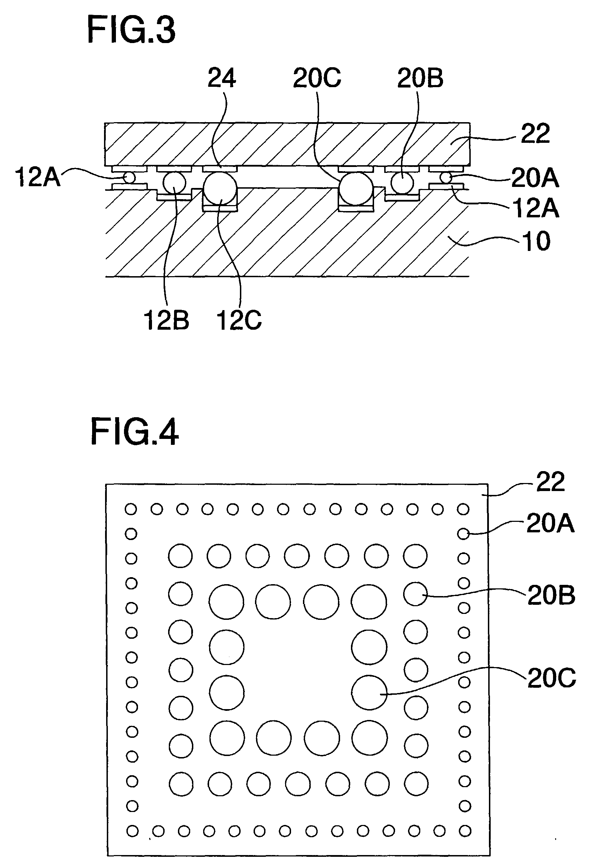

In order to connect the BGA package 22 shown in FIGS. 2(A) and 2(B) to the printed circuit board 10 shown in FIGS. 1(A) to 1(C), cream solder is first applied to the pads 12A, 12B and 12C of the printed circuit board 10, and then the BGA package 22 shown in FIGS. 2(A) and 2(B) is placed onto the printed circuit board 10 such that the tops of the solder balls may directly contact with the corresponding pads 12A, 12B and 12C. Then, solder connection is performed by heating by reflow or the like. FIG. 3 shows the printed circuit board 10 and the BGA package 22 in the connected state. The solder balls 20A in the outermost row of the BGA package 22 are connected to the pads 12A of the printed circuit board 10, and the solder balls 20B in the next row are inserted into the recesses 14B and connected to the pads 12B. Further, the solder balls 20C in the last innermost row are inserted into the recesses 14C and connected to the pads 12C.

In the printed circuit board 10 and the BGA package 22 described hereinabove with reference FIGS. 1(A) to 1(C) and 2(A) and 2(B), the pads have individually equal sizes and are arranged in a grid-like configuration in an equal pitch. However, since the solder balls are formed such that the size decreases toward the outside row, they can be arranged in a decreasing pitch toward the outside row.

FIG. 4 shows a modified BGA package 22 wherein solder balls are arranged such that the pitch thereof decreases toward the outer row. Similarly as in FIGS. 2(A) and 2(B), a solder ball on the outermost row is denoted by 20A, a solder ball on the middle row by 20B, and a solder ball on the innermost row by 20C. In this instance, the pads to which the solder balls are to be connected must be set such that the size decreases toward the outer row. In FIG. 4, the pads are omitted for simplified illustration. According to the arrangement shown in FIG. 4, wiring in a higher density than in the arrangement of FIGS. 1(A) to 1(C) can be achieved.

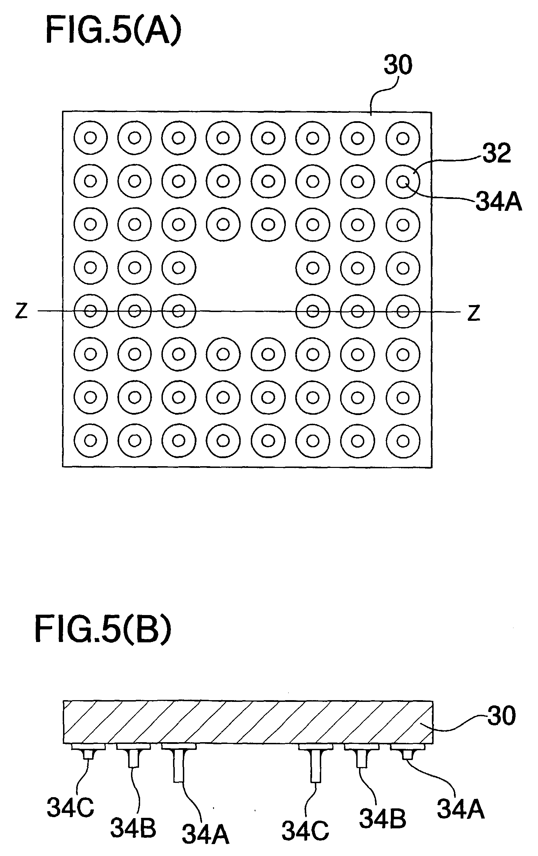

In order to connect a printed circuit board and a semiconductor package to each other, a pin may be used in place of a solder ball. In this instance, a pin package is used in place of a BGA package. Where the printed circuit board of a multilayer structure shown in FIGS. 1(A) to 1(C) is used as a printed circuit board to be connected, such a pin package 30 as shown in FIGS. 5(A) and 5(B) may be used.

Referring to FIGS. 5(A) and 5(B), the pin package 30 includes a large number of pins 34A, 34B and 34C connected to pads 32 disposed in a grid-like configuration by soldering and so dimensioned that the length increases toward the inner side from the outer side as seen in FIG. 5(B). The shortest pins 34A are connected to the pads 32 of the outermost row along the four sides of the pin package 30, and the medium length pins 34B are connected to the pads 32 of the middle row along the four sides of the pin package 30. Further, the longest pins 34C are connected to the pads 32 of the innermost row along the four sides of the pin package 30. The lengths of the pins are selected such that, when the pin package 30 of FIGS. 5(A) and 5(B) is connected to the printed circuit board 10 of FIGS. 1(A) to 1(C), the ends of the pins 34A, 34B and 34C contact with the pads 12A, 12B and 12C of the printed circuit board 10 as described below.

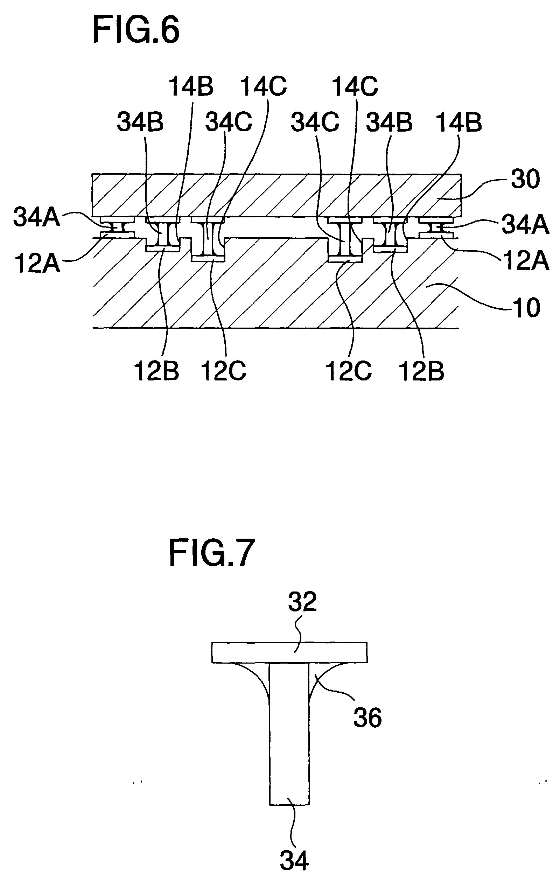

FIG. 7 shows a pin 34 (34A, 34B or 34C) soldered to a pad 32. A solder fillet 36 is formed at a base portion of the pin 34.

In order to connect the pin package 30 shown in FIGS. 5(A) and 5(B) to the printed circuit board 10 shown in FIGS. 1(A) to 1(C), cream solder is applied to the pads 12A, 12B and 12C of the printed circuit board 10, and the pin package 30 shown in FIGS. 5(A) and 5(B) is placed onto the printed circuit board 10. Then, solder connection is performed by heating by reflow or the like. FIG. 6 shows the printed circuit board 10 and the pin package 30 connected to each other. The pins 34A of the pin package 30 are connected directly to the pads 12A of the printed circuit board 10, and the pins 34B are connected directly to the pads 12B. Further, the pins 34C are connected directly to the pads 12C.

While preferred embodiments of the present invention have been described using specific terms, such description is for illustrative purposes only, and it is to be understood that changes and variations may be made without departing from the invention.

## Claims

1. A connection method to a printed circuit board for establishing electric connection to a pad (12B, 12C) embedded together with a wiring line (11) in an inner layer of a printed circuit board (10) of a multilayer structure, characterized in that it comprises the steps of:

   removing an insulating material on the pad (12B, 12C) to form a recessed portion (14B, 14C) in the printed circuit board (10) to expose the pad (12B, 12C) through the recessed portion (14B, 14C); and
   connecting a connection member (20B, 20C; 34B, 34C) directly to the pad (12B, 12C) through the recessed portion (14B, 14C).

2. A connection method to a printed circuit board as set forth in claim 1, characterized in that the recessed portion (14B, 14C) is formed by mechanical spot facing of the insulating material.

3. A connection method to a printed circuit board as set forth in claim 1, characterized in that the recessed portion (14B, 14C) is formed by thermal vaporization of the insulating material by a laser.

4. A connection method to a printed circuit board as set forth in claim 1, 2 or 3, characterized in that the connection member (20B, 20C; 34B, 34C) is connected to the pad (12B, 12C) by soldering.

5. A connection method to a printed circuit board as set forth in any one of claims 1 to 4, characterized in that the connection member is a solder ball (20B, 20C).

6. A connection method to a printed circuit board as set forth in any one of claims 1 to 4, characterized in that the connection member is a pin (34B, 34C).

7. A connection method to a printed circuit board for electrically connecting a connection member (20B, 20C; 34B, 34C) of a semiconductor package (22; 30) to a pad (12B, 12C) embedded together with a wiring line (11) in an inner layer of a printed circuit board (10) of a multilayer structure, characterized in that it comprises the steps of:

> removing an insulating material on the pad (12B, 12C) to form a recessed portion (14B, 14C) of a depth corresponding to the size of the connection member (20B, 20C; 34B, 34C) in the printed circuit board (10) to expose the pad (12B, 12C) through the recessed portion (14B, 14C); and
> placing the semiconductor package (22; 30) onto the printed circuit board (10) and connecting the connection member (20B, 20C; 34B, 34C) directly to the pad (12B, 12C) through the recessed portion (14B, 14C).

8. A connection method to a printed circuit board as set forth in claim 7, characterized in that another connection member (20A; 34A) of the semiconductor package (22; 30) is connected to another pad (12A) provided on the surface of the printed circuit board (10).

9. A connection method to a printed circuit board as set forth in claim 7 or 8, characterized in that the recessed portion (14B, 14C) is formed by mechanical spot facing of the insulating material.

10. A connection method to a printed circuit board as set forth in claim 7 or 8, characterized in that the recessed portion (14B, 14C) is formed by thermal vaporization of the insulating material by a laser.

11. A connection method to a printed circuit board as set forth in any one of claims 7 to 10, characterized in that the connection member (20B, 20C; 34B, 34C) is connected to the pad (12B, 12C) by soldering.

12. A connection method to a printed circuit board as set forth in any one of claims 7 to 11, characterized in that the connection member is a solder ball (20B, 20C).

13. A connection method to a printed circuit board as set forth in any one of claims 7 to 11, characterized in that the connection member is a pin (34B, 34C).

14. A connection method to a printed circuit board as set forth in claim 12, characterized in that a plurality of solder balls (20B, 20C) are arranged in concentrical rows on the semiconductor package (22) such that the diameter increases as the arrangement position comes toward the center of the rows.

15. A connection method to a printed circuit board as set forth in claim 13, characterized in that a plurality of pins (34B, 34C) are arranged in concentric rows on the semiconductor package (30) such that the length increases as the arrangement position comes toward the center of the rows.

16. A connection structure to a printed circuit board for establishing electric connection to a pad (12B, 12C) embedded together with a wiring line (11) in an inner layer of a printed circuit board (10) of a multilayer structure, characterized in that it comprises

> a recessed portion (14B, 14C) formed on the pad (12B, 12C) and defined by an insulating material for exposing said pad (12B, 12C) therethrough; and
> a connection member (20B, 20C; 34B, 34C) connected directly to said pad (12B, 12C) through said recessed portion (14B, 14C).

17. A connection structure to a printed circuit board as set forth in claim 16, characterized in that said connection member is a solder ball (20B, 20C).

18. A connection structure to a printed circuit board as set forth in claim 16, characterized in that said connection member is a pin (34B, 34C).

19. A connection structure to a printed circuit board for electrically connecting a connection member (20B, 20C; 34B, 34C) of a semiconductor package (22; 30) to a pad (12B, 12C) embedded together with a wiring line (11) in an inner layer of a printed circuit board (10) of a multilayer structure, characterized in that

> a recessed portion (14B, 14C) of a depth corresponding to the size of said connection member (20B, 20C; 34B, 34C) is formed on said pad (12B, 12C) in said printed circuit board (10) and defined by an insulating material for exposing said pad (12B, 12C) therethrough, and
> said connection member (20B, 20C; 34B, 34C) arranged on said semiconductor package (22; 30) is connected directly to said pad (12B, 12C) through said recessed portion (14B, 14C).

20. A connection structure to a printed circuit board as set forth in claim 19, characterized in that another connection member (20A; 34A) of said semiconductor package (22; 30) is connected to another pad (12A) provided on the surface of said printed circuit board (10).

21. A connection structure to a printed circuit board as set forth in claim 19, characterized in that said connection member is a solder ball (20B, 20C).

22. A connection structure to a printed circuit board as set forth in claim 21, characterized in that a plurality of solder balls (20A, 20B, 20C) are arranged in concentrical rows on said semiconductor package (22).

23. A connection structure to a printed circuit board as set forth in claim 22, characterized in that said plurality of solder balls (20A, 20B, 20C) are arranged such that the arrangement pitch thereof increases from the outer row toward the inner row.

24. A connection structure to a printed circuit board as set forth in claim 22 or 23, characterized in that said plurality of solder balls (20A, 20B, 20C) are arranged such that the diameter increases as the arrangement position comes toward the center of the rows.

25. A connection structure to a printed circuit board as set forth in claim 19, characterized in that said connection member is a pin (34B, 34C).

26. A connection structure to a printed circuit board as set forth in claim 25, characterized in that a plurality of pins (34A, 34B, 34C) are arranged in concentrical rows on said semiconductor package (30).

27. A connection structure to a printed circuit board as set forth in claim 26, characterized in that said plurality of pins (34A, 34B, 34C) are arranged such that the arrangement pitch thereof increases from the outer row toward the inner row.

28. A connection structure to a printed circuit board as set forth in claim 26 or 27, characterized in that said plurality of pins (34A, 34B, 34C) are arranged such that the length increases as the arrangement position comes toward the center of the rows.

# FIG.1(A)

# FIG.1(B)

# FIG.1(C)

## FIG.2(A)

## FIG.2(B)

## FIG.3

## FIG.4

# FIG.5(A)

# FIG.5(B)

# FIG.6

# FIG.7

# FIG.8(A)

PRIOR ART

60    64   66    74    76

62    R ---[⊙]---[⊙]--- R

68    78

# FIG.8(B)

PRIOR ART

72    70

# FIG.8(C)

PRIOR ART

82    80

# FIG.9

## PRIOR ART

68  66        76   78

61    70              80

# FIG.10

## PRIOR ART

86        88

85